# EUROPÄISCHE PATENTSCHRIFT

(11) **EP 2 855 144 B1**
(45) Veröffentlichungstag und Bekanntmachung des Hinweises auf die Patenterteilung: **21.06.2017**
(21) Anmeldenummer: 13725156.7
(22) Anmeldetag: 27.05.2013
(51) Int. Cl.: B32B 7/02, B32B 27/06, B32B 27/16, B32B 27/36, B29D 11/00, C23C 14/14, C23C 16/00, G02B 1/04, G02B 5/26, G02B 5/08

(54) **MEHRSCHICHTAUFBAU ALS REFLEKTOR**
MULTILAYER STRUCTURE AS REFLECTOR
STRUCTURE MULTICOUCHE SERVANT DE RÉFLECTEUR

(30) Priorität: 01.06.2012 EP 12170439
(43) Veröffentlichungstag der Anmeldung: 08.04.2015
(73) Patentinhaber: Covestro Deutschland AG, 51373 Leverkusen (DE)
(72) Erfinder: KUHLMANN, Timo, 42799 Leichlingen (DE); OSER, Rafael, 47800 Krefeld (DE)
(74) Vertreter: Levpat
(86) Internationale Anmeldenummer: PCT/EP2013/060822
(87) Internationale Veröffentlichungsnummer: WO 2013/178563

(56) Entgegenhaltungen:
- WO-A1-2009/114493
- JP-A- 2012 037 634

## Beschreibung

Die vorliegende Erfindung betrifft einen Mehrschichtaufbau enthaltend mehrere Schichten mit verbesserten Klebeeigenschaften zur Anwendung als Spiegel beispielsweise innerhalb der Bereiche CPV (concentrating photovoltaics) und CSP (concentrating solar power), innerhalb von Beleuchtungssystemen sowie für Spiegel und Reflektoren im Innen- und Außeneinsatz. Der Mehrschichtaufbau umfasst (von unten nach oben) mindestens eine Substratschicht, eine metallhaltige Schicht und eine reflektierende Funktionsfolie. Ferner betrifft die Erfindung ein Verfahren zu seiner Herstellung sowie eine vorteilhafte Verwendung.

JP 2012-037634 A beschreibt eine Sonnenstrahlen reflektierende mehrlagige Folie enthaltend eine Polyesterfolie als Trägerfolie enthaltend eine spezielle Folge von 5 übereinanderliegenden Schichten (ZnO/Ag/ZnO/Ag/ZnO) zur Erhaltung einer Reflexionsschicht mit guten optischen Eigenschaften. Dieses Dokument betrifft unterschiedliche Metalloxid-Schichten zum Schutz der Reflexionsschicht Ag im Vergleich zu bekannten Metalloxid-Schichten (z.B. Titandioxid) zum Schutz von Ag.

WO2009/114493 beschreibt einen speziellen Spiegelaufbau auf Glas als Substrat, der spezielle Metalloxid-Schichten zum Schutz der reflektierenden Silberschicht bei hohen Produktionstemperaturen bieten soll. Bei der in diesem Dokument beschriebenen Klebeschicht handelt es sich um eine haftvermittelnde Schicht und nicht um eine Klebeschicht wie in der vorliegenden Anmeldung. Bei der Verklebung dünner Funktionsfolien mit Hilfe eines PSA ("Pressure Sensitive Adhesive") auf Thermoplasten wie z.B. Polycarbonat wird nach kurzer Zeit im Außeneinsatz (beim Klimawechsel) eine nicht akzeptable Blasenbildung der aufgeklebten Folie beobachtet. Hierdurch kann die Funktionalität der aufgeklebten Funktionsfolie beeinträchtigt werden, was insbesondere bei Anwendungen im Bereich der CPV (concentrating photovoltaics) und CSP (concentrating solar power) nicht erwünscht ist.

Ein alternatives Klebemittel kommt für die Verklebung der Funktionsfolie mit dem Thermoplast nicht in Frage, da durch die Verwendung eines PSA die aufgeklebte Funktionsfolie auf dem Thermoplast bei Bedarf ausgetauscht werden kann.

Aufgabe der vorliegenden Erfindung ist es daher die oben beschriebene Blasenbildung des Laminates im Außeneinsatz zu vermeiden und somit die Funktionalität des Laminates dauerhaft zu erhalten.

Die Aufgabe wird erfindungsgemäß mit einem Mehrschichtaufbau enthaltend
A) Eine Funktionsfolie enthaltend eine VIS/IR-reflektierende Metallschicht auf einer Trägerfolie, wobei die Trägerfolie einschichtig oder in Form einer UV- und/oder UV/VIS-reflektierenden Multilagenschicht ausgeführt sein kann sowie mindestens eine Klebeschicht, wobei die Klebeschicht ein Pressure Sensitive Adhesive ist, sowie optional mindestens eine Kratzfestschicht
B) eine Funktionsschicht enthaltend eine Schicht aus Metallnitriden, Metall- oder Halbmetalloxiden, Mischoxiden oder Metallen, wobei die Schicht zusätzlich eine Lackierung aufweisen kann,
C) optional eine Trägerfolie,
D) optional eine Klebeschicht,
E) eine thermoplastische Substratschicht.

Überraschenderweise wurde gefunden, dass durch eine spezielle Oberflächenmodifikation des thermoplastischen Substrats, insbesondere Polycarbonat, die oben beschriebene Blasenbildung zu vermeiden ist. Die spezielle Oberflächenmodifikation besteht in der Abscheidung einer Metall- oder Halbmetalloxid-Schicht, wie zum Beispiel einer SiO₂-Schicht. Überraschenderweise ist nicht jede Metall- oder Halbmetalloxid-Schicht zur Haftvermittlung geeignet. So sind SiO₂-Schichten, die nach einem Sol-Gel-Verfahren produziert und auf das Substrat aufgebracht wurden nicht geeignet, um die Blasenbildung zu verhindern. Demgegenüber zeigen erfindungsmäße SiO₂-Schichten, die in einem PVD (Physical Vapor Deposition) Prozess oder CVD (Chemical Vapor Deposition) Prozess aufgebracht wurden, eine ausreichende Fähigkeit die Blasenbildung zu verhindern. Metalloxid-Schichten (wie Al₂O₃), die im PVD-Prozess abgeschieden werden, sind ebenfalls geeignet. Auch sind bestimmte Metall-Schichten, wie z.B. Aluminium geeignet. Hierbei ist jedoch die Korrosionsempfindlichkeit des Metalls im Außeneinsatz zu beachten. So ist ein Anlaufen von z.B. Aluminium in dieser Anwendung zu beobachten.

Eine Ausführungsform der Erfindung ist weiterhin ein Mehrschichtaufbau gemäß der vorliegenden Erfindung, bei dem die Funktionsschicht B) sich auf einer Trägerfolie C) befindet.

Die Abscheidung der Funktionsschicht B auf eine Trägerfolie C) und nachfolgendem Fügen der so erhaltenen Folie aus B) und C) mittels einer Klebeschicht D) auf ein Polycarbonat Substrat E) führt ebenfalls zu einer erfindungsgemäßen Oberflächenmodifikation und ist Gegenstand der vorliegenden Erfindung.

Gegenstand der vorliegenden Erfindung ist weiterhin ein Verfahren zur Herstellung eines Mehrschichtaufbaus enthaltend die Schichten A) bis E), bei dem
a) die Schichten A) und B) und C) mittels einer Klebeschicht D) auf die Substratschicht E) aufgebracht wird oder
b) die Schicht B) auf eine Trägerfolie C) aufgebracht wird, die so erhaltene Folie mittels einer Klebeschicht D) auf eine Substratschicht E) aufgebracht wird und anschließend die Schicht A) aufgebracht wird.

Die einzelnen Schichten können wie folgt ausgebildet sein:

### Schicht A)

Als thermoplastische Kunststoffe für die Trägerfolie der Schicht A) bei einschichtiger Ausführung sind bevorzugt Polycarbonat, Co-Polycarbonate, Polyestercarbonate, Polystyrol, Styrol-Copolymere, aromatische Polyester wie Polyethylenterephthalat (PET), PET-Cyclohexandimethanol-Copolymer (PETG), Polyethylennaphthalat (PEN), Polybutylenterephthalat (PBT), aliphatische Polyolefine wie Polypropylen oder Polyethylen, cyclisches Polyolefin, Poly- oder Copolyacrylate und Poly- oder Copolymethacrylat wie z.B. Poly- oder Copolymethylmethacrylate (wie PMMA) sowie Copolymere mit Styrol wie z.B. transparentes Polystyrolacrylnitril (PSAN), thermoplastische Polyurethane, Polymere auf Basis von zyklischen Olefinen (z.B. TOPAS^{®}, ein Handelsprodukt der Firma Ticona), Polycarbonat Blends mit olefinischen Copolymeren oder Pfropfpolymeren, wie beispielsweise Styrol/Acrylnitril Copolymeren.

Besonders bevorzugt sind PMMA, PET, PEN, PETG, Polycarbonat sowie Co-Polycarbonat, ganz besonders bevorzugt sind PMMA, PET oder PEN als Material für die Trägerfolie. Ganz besonders bevorzugt ist PET.

Hierbei können die vorgenannten Polymere alleine oder in Mischungen eingesetzt werden.

Handelt es sich bei der Trägerfolie um die UV- und/oder UV/VIS-reflektierende Multilagenschicht so sind nachfolgende Materialkombinationen in alternierender Reihenfolge als optisch aktive Schichten verwendbar. Es werden bevorzugt Schichtkombinationen bestehend aus PET (Polyethylenterephthalat) und THV (Tetrafluorethylen Hexafluorpropylen Vinyliden Fluorid), aus PET und OTP (polydiorganosiloxane polyoxamide block copolymers), aus PEN und THV, aus PEN und OTP, aus PEN und PMMA, aus PET und coPMMA, aus PEN und coPMMA-Schichtpaaren, aus coPEN und PMMA-Schichtpaaren, aus coPEN und OTP, aus coPEN und THV, aus sPS (syndiotaktisches Polystyrol) und OTP, aus sPS und THV, aus PMMA und THV, aus COC und THV, oder aus EVA-Schicht und THV-Paaren eingesetzt.

Derartige reflektierende Multilagenschichten sind bekannt und sind unter anderem US 3,610,724, US 3,711,176, US 4,446,305, US 4.540,623, US 5,448,404, US 5,882,774, US 6,045,894, US 6,531,230, WO 99/39224, US 2001/0022982 A1 beschrieben.

Die VIS/IR-reflektierende Metallschicht kann jedes Metall oder jede Metallkombination enthalten, die VIS/IR-Strahlung effizient reflektiert. Im Allgemeinen sollte die Metallschicht ca. 100nm dick sein um ein hohes Reflexionsvermögen zu gewährleisten. Bevorzugte Metalle sind Silber, Kupfer, Aluminium, Kupfer auf Silber, Nickel-Chrom, rostfreiem Stahl und / oder Nickel oder deren Kombinationen. Besonders bevor sind Kombinationen enthaltend Silber.

In einer bevorzugten Ausführungsform ist die Silberschicht auf der einen Seite mit einer Aluminiumschicht und auf der anderen Seite von einer Kupferschicht umgeben.

Die Metallschicht bzw. die Metallschichten können auf die Trägerfolie bzw. auf die UV- und/oder UV/VIS-reflektierende Multilagenschicht durch jede geeignete Technik einschließlich der Laminierung, des Sputterns und des Aufdampfens gefügt werden.

Schichtsysteme A) enthaltend eine Trägerfolie bzw. eine UV- und/oder UV/VIS-reflektierende Multilagenschicht als Trägerfolie kombiniert mit einer VIS/IR-reflektierenden Metallschicht werden auch als Breitbandreflektor bezeichnet.

In einigen Ausführungsformen weist der Breitbandreflektor eine mittlere Lichtreflexionsvermögen von mindestens 95 Prozent in einem Wellenlängenbereich von 350 bis 400 Nanometern auf.

In einigen Ausführungsformen weist der Breitbandreflektor eine mittlere Lichtreflexionsvermögen von mindestens 90 Prozent in einem Wellenlängenbereich von 300 bis 2494 Nanometer auf.

Geeignete Klebstoffe, die bei der Herstellung von Breitbandreflektoren sowie als Klebeschicht der Schicht A) gemäß der vorliegenden Erfindung verwendet werden können, sind optisch transparent und angemessen UV-Licht stabil oder nicht.

Als Klebstoffe werden so genannte PSA, Pressure Sensitive Adhesives, eingesetzt. Unter PSA versteht man Kleber, die bereits bei Raumtemperatur permanent klebrig sind und eine innige Haftung zu anderen Oberflächen aufweist. Diese Haftung tritt bereits bei Ausübung eines leichten Drucks, wie er beispielsweise mit Fingerkraft ausgeübt werden kann, ein.

Verbindungsklassen für PSA sind beispielsweise Acrylate, Polyurethane, Polyalphaolefine, Silicone oder klebrig gemachter natürlicher oder synthetischer Kautschuk.

Weiterhin kann klebrig-gemachtes OTP als Klebstoff, wie in US-Patentnummer 7,371,464 B2 (Sherman et al.) beschrieben, verwendet werden.

Weitere bevorzugte Klebstoffe sind "nicht-silikonbasierte-Haftkleber", die unter Anderem in WO2009085662A2 mit dem Titel "Urea-Based Pressure Sensitive Adhesives" sowie in US20120100326A1 mit dem Titel "Urethane-Based Pressure Sensitive Adhesives" beschrieben wurden.

Für nicht lichtempfindliche Aufbauten kann eine beliebige Klebstoffzusammensetzung, beispielsweise ein Epoxid-, Urethan-, Silikon- oder Acrylkleber oder eine Kombination davon verwendet werden.

Bevorzugt sind im Rahmen der Erfindung Klebstoffe aus der Klasse der optisch klaren druckempfindlichen Acrylklebstoffe.

Kommerziell verfügbare Acrylklebstoffe sind LAMINATING ADHESIVE 8141 oder LAMINATING ADHESIVE 8171, 8172 und 8173D von der Firma 3M.

Die Klebstoffzusammensetzung kann zum Beispiel ein Haftkleber, ein wärmehärtender Klebstoff, einen Schmelzklebstoff, oder eine Kombination davon sein.

Die Schicht A) kann an der Grenzfläche zur Außenumgebung durch eine Kratzfestschicht abgeschlossen werden. Diese kann prinzipiell jegliches abriebfestes Material sein, das für die reflektierten Wellenlängen des Breitbandreflektors durchlässig ist.

In einer Ausführungsform besteht die Kratzfestschicht aus einem thermoplastischen Urethan (Handelsname Tecoflex) von Lubrizol Advanced Materials Inc. enthaltend 5 Gew.-% Tinuvin 405, 2 Gew.-% Tinuvin 123 und 3 Gew.-% Tinuvin 1577 jeweils von der BASF SE.

In einer Ausführungsform besteht die Kratzfestschicht aus einer thermisch-härtbaren sowie silikonbasierten Polymerzusammensetzung (Handelsname PERMA-NEW 6000 (oder PERMA-NEW 6000B) CLEAR HARD COATING SOLUTION) von California Hardcoating Co.

Die Kratzfestschicht kann eine beliebige Dicke in Abhängigkeit des verwendeten Materials haben. Typische Schichtdicken belaufen sich auf eine Größenordnung von 1 Mikrometer bis 10 Mikrometer, bevorzugt 3 Mikrometer bis 6 Mikrometern.

Die Kratzfestschicht kann optional eine schmutzabweisende Komponente beinhalten. Beispiele für schmutzabweisende Komponenten umfassen Fluorpolymere, Silikonpolymere, und Titandioxid-Teilchen, Fluorpolymere, Silikonpolymere, Titandioxid-Teilchen, polyedrische oligomere Silsesquioxane (z. B. POSS von der Firma Hybrid Plastics) sowie deren Kombinationen.

In weiteren Ausführungsformen der Kratzfestbeschichtungen sind thermisch härtende Beschichtungssysteme auf Basis eines Polysiloxanlackes, die sowohl einschichtig als auch mehrschichtig (mit einer lediglich haftvermittelnden Primerschicht zwischen Substrat und Polysiloxandecklack) sein können. Diese sind u. a. in US 4,278,804, US 4,373,061,US 4,410,594, US 5,041,313 und EP-A-1 087 001 beschrieben. Beispielhaft sind hier die kommerziell erhältlichen Systeme der Momentive Performance Materials Inc. Wilton, CT USA wie PHC 587; PHC 587B, PHC 587C; SHP 401 (Primer) / AS 4000 (Topcoat) oder auch SHP 401 (Primer) / AS 4002 (Topcoat) erwähnt sowie - KASI Flex^{®} oder Sun Flex^{®}, beide von KRD Coatings, Geesthacht, Deutschland, oder Silvue^{®} MP 100, SDC Coatings, Deutschland, oder Sicralan^{®} MRL von GFO, Schwäbisch Gmünd, Deutschland.

In weiteren Ausführungsformen der Kratzfestbeschichtungen sind thermisch härtende Mehrschichtsysteme mit einem UV-Schutzprimer und einem Decklack auf Basis eines Polysiloxanlackes. Geeignete Systeme sind bekannt z.B. aus US 5,391,795 und US 5,679,820 und "Paint & Coating Industrie; July 2001 Seite 64 bis 76: The Next Generation in Weatherable Hardcoats for Polycarbonate" by George Medford / General Electric Silicones, LLC, Waterford, NY; James Pickett / The General Electric Co., Corporate Research and Development, Schenectady, NY; and Curt Reynolds / Lexamar Corp., Boyne City, MI. Ein kommerziell erhältliches System ist das darin erwähnte SHP470 (UV-Schutzprimer) oder SHP470FT (UV-Schutzprimer) / AS4700 (Decklack) System der Momentive Performance Materials. Dieser SHP470 oder SHP470FT ist ein haftvermittelnder UV-Schutzprimer auf Basis Polymethymethacrylat unter anderem mit 1-Methoxy-2-propanol und Diacetonalkohol als Lösemittel und Dibenzoylresorcin als UV-Absorber. Der AS4700 Decklack ist ein Polysiloxandecklack mit silyliertem UV-Absorber.

In weiteren Ausführungsformen können UV-härtende Beschichtungssysteme z.B. auf Acrylat-, Urethanacrylat oder Acrylsilanbasis, die gegebenenfalls Füllstoffe zur Verbesserung der Kratzfestigkeit beinhalten, aufgrund ihres größeren Applikationsschichtdickenfensters einen ausreichenden Witterungsschutz und Kratzschutz bilden. Solche Systeme sind bekannt und u.a. beschrieben in US 3,707,397 oder DE 69 71 7959, US 5,990,188, US 5,817,715, und US 5,712,325. Beispielhaft für eine solche geeignete Beschichtung sind die kommerziell erhältlichen UVHC 3000, UVHC 3000K und UVHC 3000S Systeme der Firma Momentive Performance Materials oder UVT 200 und UVT 610 der Fa. Redspot.

Bei allen zuvor genannten Kratzfestbeschichtungen ist der Anteil des oder der Lichtschutzmittel, UV-Absorber und/oder Radikalfänger in derart zu wählen, dass es zu keinem unerwünschten Effekt bezüglich der Reflexion der UV-, UV/VIS- und/oder VIS/IR-reflektierenden Schichten kommt.

Zuvor beschriebene Funktionsfolien sind bekannt und werden beispielsweise in WO 2010/078105 beschrieben. Kommerziell verfügbar sind derartige Funktionsfolien unter den nachfolgenden Handelsnamen Reflectech^{®} Mirror Film von Reflectech oder Silver Reflector von Southwall oder Solar Mirror Film 1100 (SMF1100) von der 3M.

### Schicht B)

Die erfindungsgemäß vorgesehene Schicht B) umfasst mindestens eine Metallschicht, Metall- oder Halbmetalloxidschicht, Metallnitridschicht oder Mischoxidschicht sein.

Die Metalle, Metall- oder Halbmetalloxide, Metallnitride und Mischoxide sind ausgewählt aus Aluminium, Kupfer, Silber, Titan, Chrom, Chromlegierungen, VA-Stahl, Gold, Platin, Aluminiumoxid, Titandioxid, Siliziumoxid SiOₓ, Tantalpentoxid Ta₂O₅, Zirkonoxid, Zirkondioxid, Nb₂O₅, HfO, Zink-Zinnoxid, Indium-Zinnoxid, Aluminium-Zinkoxid, Siliziumnitrid, Bornitrid oder Titannitrid. Bevorzugte Schichtmaterialien sind ausgewählt aus Aluminium, VA-Stahl, Kupfer, Titan, Aluminiumoxid, Siliziumoxid SiOₓ, Siliziumnitrid oder Zink-Zinnoxid.

Die Schichtdicken betragen 5nm bis 300nm, bevorzugt von 10nm bis 200nm, besonders bevorzugt von 20nm bis 180nm.

Oberhalb und / oder unterhalb der Metallschicht, Metall- oder Halbmetalloxidschicht, Metallnitridschicht oder Mischoxidschicht kann sich eine oder mehrere Beschichtungsschichten befinden.

Des Weiteren können einerseits die Metallschicht, Metall- oder Halbmetalloxidschicht, Metallnitridschicht oder Mischoxidschicht und andererseits die Beschichtungsschichten alternierend angeordnet sein.

Beispiele, die derartige Mehrschichtkonzepte näher erläutert ohne auf diese beschränkt zu sein, sind die Patente EP2272928A1, EP792846A1, US20030077462, EP2268390A1, EP1217052A2, WO2010127808A1 sowie WO2007051860A1 sowie darin enthaltene Zitate.

### Aufbringen der Schicht B)

Die Schichten B) werden entweder durch einen PVD Prozess oder einen CVD Prozess auf die Schicht C) oder Schicht E) aufgebracht. Die Verfahren sind näher beschrieben z.B. in "Vakuumbeschichtung Bd.1 bis 5", H. Frey, VDI-Verlag Düsseldorf 1995 oder "Oberflächen- und Dünnschicht-Technologie" Teil 1, R.A. Haefer, Springer Verlag 1987. Weitere Verfahren sind unter anderem beschrieben in Surface and Coatings Technology 111 (1999), 287-296.

Um eine bessere Metallhaftung zu erreichen und um die Substratoberfläche zu reinigen, werden die Substrate normalerweise einer Plasmavorbehandlung unterzogen. Eine Plasmavorbehandlung kann u. U. die Oberflächeneigenschaften von Polymeren verändern. Diese Methoden sind z.B. bei Friedrich et al. in Metallized plastics 5 & 6: Fundamental and applied aspects und H. Grünwald et al. in Surface and Coatings Technology 111 (1999) 287-296 beschrieben.

### Schicht C)

Zuvor genannte Schichten B) können hierbei auch auf eine Trägerfolie (Schicht C)), die ausgewählt ist aus einem thermoplastischen Kunststoff, abgeschieden werden.

Als thermoplastische Kunststoffe für die Schicht C) sind bevorzugt Polycarbonat, Co-Polycarbonat, Polyestercarbonat, Polystyrol, Styrol-Copolymere, aromatische Polyester wie Polyethylenterephthalat (PET), PET-Cyclohexandimethanol-Copolymer (PETG), Polyethylennaphthalat (PEN), Polybutylenterephthalat (PBT), aliphatische Polyolefine wie Polypropylen oder Polyethylen, cyclisches Polyolefin, Poly- oder Copolyacrylate und Poly- oder Copolymethacrylat wie z.B. Poly- oder Copolymethylmethacrylate (wie PMMA) sowie Copolymere mit Styrol wie z.B. transparentes Polystyrolacrylnitril (PSAN), thermoplastische Polyurethane, Polymere auf Basis von zyklischen Olefinen (z.B. TOPAS^{®}, ein Handelsprodukt der Firma Ticona), Polycarbonat Blends mit olefinischen Copolymeren oder Pfropfpolymeren, wie beispielsweise Styrol/Acrylnitril Copolymeren.

Besonders bevorzugt ist PMMA, PET, PEN, PETG, Polycarbonat, Co-Polycarbonat oder Polyestercarbonat. Ganz besonders bevorzugt ist PMMA, PET oder PEN. Hierbei können die vorgenannten Polymere alleine oder in Mischungen eingesetzt werden.

Bevorzugte Foliendicken der thermoplastischen Schicht C) sind 10µm bis 500µm. Besonders bevorzugte Foliendicken sind 20µm bis 250µm. Ganz besonders bevorzugt sind 25µm bis 125µm dicke Folien als Trägermaterial.

### Schicht D)

Ein geeigneter Klebstoff der Schicht D) ist ein 2-Komponenten-Klebstoff, der aus zwei unterschiedlichen Komponenten besteht, die miteinander zu einem vernetzten Klebstofffilm abreagieren können. Insbesondere handelt es sich dabei um 2K-Polyurethan-Klebstoffe, die über NCO-Gruppen und azide H-Gruppen-haltige Bestandteile vernetzen. Beispiele dafür enthalten als Komponente A die bekannten NCO-Gruppen-haltigen Prepolymere oder Polyisocyanate, als Komponente B können die bekannten OH, NH, SH, COOH-Gruppen-haltigen Oligomere oder Polymere, die mit den NCO-Gruppen der anderen Komponente reagieren können, eingesetzt werden. Um ein Netzwerk zu erhalten ist es zweckmässig, wenn mindestens zwei NCO-Gruppen und mindestens zwei insbesondere OH-Gruppen an den vernetzenden Bestandteilen enthalten sind. Weiterhin können die an sich bekannten Zusatzstoffe in dem Klebstoff enthalten sein. Es handelt sich dabei um solche Bestandteile, mit der bestimmte Eigenschaften des Klebstoffes eingestellt und beeinflusst werden können.

Beispielsweise wird als Komponente A ein mindestens zwei Isocyanatgruppen tragendes PU-Prepolymer oder ein Gemisch solcher PU-Prepolymere eingesetzt, das beispielsweise durch Umsetzung einer Polyolkomponente mit einem mindestens difunktionellen Isocyanat im stöchiometrischen Überschuss erhältlich ist.

PU-Prepolymere im Sinne der vorliegenden Erfindung sind Umsetzungsprodukte von OH-Gruppen oder NH-Gruppen-tragenden Verbindungen mit einem Überschuss von Polyisocyanaten. Es handelt sich dabei um die für Klebstoffanwendung bekannten Polyole oder entsprechende Verbindungen mit sekundären und/oder primären Aminogruppen. Es sind OH-haltige Ausgangsverbindungen bevorzugt. Insbesondere geeignet zur Synthese dieser Prepolymere sind Polyole mit einem Molekulargewicht bis zu 20000 g/mol, insbesondere von 200 bis zu 10000 g/mol (zahlenmittleres Molekulargewicht, MN, wie durch GPC bestimmbar). Es kann sich dabei beispielsweise um Polyole auf Basis von Polyethern, Polyestern, Polyolefinen, Polyacrylaten, Alkylenpolyolen handeln. In einer anderen Ausführungsform werden solche Verbindungen mit NH-Gruppen eingesetzt.

Die Polyolkomponente kann dabei niedermolekular sein, beispielsweise von ca. 60 g/mol bis 1500 g/mol, es können jedoch auch höher molekulare Polymere umgesetzt werden, beispielsweise solche mit einem Molekulargewicht von 1500 bis 20.000 g/mol. Dabei sollen im Durchschnitt zwei reaktive Gruppen am Polyol vorhanden sein, beispielsweise Diole; es ist auch möglich, Verbindungen mit mehreren funktionellen Gruppen umzusetzen.

Eine Ausführungsform setzt bevorzugt niedermolekulare nicht-verzweigte Polyole ein, die ein Molekulargewicht von unterhalb von 1500 g/mol aufweisen, wobei diese Polyole 3 oder insbesondere 2 OH- Gruppen aufweisen sollen. Eine andere Ausführungsform setzt OH-haltige Polymere mit einem Molekulargewicht bis 20000 g/mol ein. Dabei kann auch eine höhere Anzahl von OH-Gruppen enthalten sein.

Als Polyisocyanate können bei der Prepolymersynthese die an sich bekannten Polyisocyanate mit zwei oder mehr Isocyanat-Gruppen eingesetzt werden, wie aliphatische, cycloaliphatische oder aromatische Isocyanate. Es können im Prinzip alle bekannten Polyisocyanate eingesetzt werden, insbesondere die Isomeren des Methylendiisocyanat (MDI) oder Toluylendiisocyanats (TDI), Tetramethylxylylendiisocyanat (TMXDI), 1 -Isocyanatomethyl-3-isocyanato-1 ,5,5-trimethylcyclohexan (IPDI), Naphthalin-1 ,5-diisocyanat (NDI), Hexan-1 ,6-diisocyanat (HDI). Es können auch mindestens trifunktionelle Isocyanate eingesetzt werden, wie durch Trimerisation oder Oligomerisation von Diisocyanaten, wie Isocyananurate, Carbodiimide oder Biurete. Bevorzugt werden Diisocyanate eingesetzt, insbesondere aromatische.

Durch die Menge der Isocyanate kann die Reaktionsführung beeinflusst werden. Wird ein hoher Überschuss an Isocyanaten eingesetzt, entstehen PU-Prepolymere, bei denen die OH-Gruppen in Isocyanatgruppen funktionalisiert worden sind. Dabei wird nur ein geringer Molekulargewichtsaufbau festgestellt. Werden geringere Mengen an Isocyanaten eingesetzt oder wird die Reaktion stufenweise durchgeführt, ist es bekannt, dass das Molekulargewicht der Prepolymere im Vergleich zu den Ausgangsverbindungen erhöht wird. Es muss sichergestellt sein, dass insgesamt ein Überschuss an Isocyanatgruppen bezogen auf die Gesamtreaktion eingesetzt wird. Die Umsetzung der Polyolverbindung mit den Isocyanaten kann auf bekannte Art und Weise erfolgen.

Für die Erfindung können die bekannten PU-Prepolymere mit reaktiven NCO-Gruppen eingesetzt werden. Solche sind dem Fachmann bekannt und können auch kommerziell erhalten werden. Insbesondere bevorzugt sind im Rahmen dieser Erfindung PU-Prepolymere, die auf Basis von Polyesterpolyolen oder Polyetherpolyolen durch Umsetzung mit Diisocyanaten hergestellt worden sind. In der Regel weisen die im Rahmen der vorliegenden Erfindung eingesetzten PU-Prepolymere ein Molekulargewicht von 500 bis etwa 30.000 g/mol auf, bevorzugt bis 15.000 g/mol, insbesondere von 1000 bis 5.000 g/mol. Dabei sind Prepolymere bevorzugt, die nur einen geringen Anteil an monomeren, nicht umgesetzten Diisocyanaten enthalten, z.B. unter 1 Gew-%.

Eine andere Ausführungsform setzt als Komponente A monomere, oligomere oder polymere Isocyanate ein. Es kann sich dabei beispielsweise um die oben erwähnten Polyisocyanate handeln oder ihre Carbodiimide, Isocyanurate oder Biurete. Es sind auch Mischungen von Prepolymeren und Polyisocyanaten möglich.

Zusätzlich zu den geeigneten NCO-Gruppen aufweisenden Bestandteilen kann die Komponente A noch weitere Hilfsstoffe und Additive enthalten. Es ist darauf zu achten, dass hierbei nur solche Bestandteile zugesetzt werden, die nicht mit den Isocyanatgruppen reagieren können. So kann eine Lagerstabilität sichergestellt werden.

Die Komponente B eines geeigneten 2-K PU-Klebstoffs muss mindestens eine Verbindung enthalten, die mindestens zwei gegenüber Isocyanatgruppen reaktive Gruppen aufweist. Beispielsweise kann es sich dabei um SH-, COOH-, NH- oder OH-Gruppen handeln. Insbesondere sind Polyole bevorzugt, wobei es sich auch um Mischungen von Polyolen unterschiedlicher chemischer Struktur oder unterschiedlichen Molekulargewichts handeln kann.

Als Polyolkomponente zum Einsatz in der Komponente B ist eine Vielzahl von Polyolen geeignet. Es kann sich beispielsweise um solche mit zwei bis zu 10 OH-Gruppen pro Molekül handeln. Es können aliphatische Verbindungen sein, es kann sich um aromatische Verbindungen handeln, es können auch Polymere eingesetzt werden, die eine ausreichende Anzahl von OH-Gruppen tragen. Es kann sich um primäre oder sekundäre OH-Gruppen handeln, soweit eine ausreichende Reaktivität mit den Isocyanatgruppen gegeben ist. Das Molekulargewicht solcher Polyole kann in weiten Grenzen variieren, beispielsweise von 500 bis 10.000 g/mol betragen. Es können die oben bereits geschriebenen Polyole enthalten sein.

Beispiele für solche Polyole sind niedermolekulare aliphatische Polyole mit bevorzugt zwei bis zehn OH-Gruppen, insbesondere C2 bis C36-Akohole. Eine andere Gruppe geeigneter Polyole sind beispielsweise Polyether. Es handelt sich dabei um die Umsetzungsprodukte von Alkylenoxiden mit 2 bis 4 C-Atomen mit niedermolekularen 2- oder 3- funktionellen Alkoholen. Dabei sollen die Polyetherpolyole ein Molekulargewicht von insbesondere 400 bis 5000 g/mol aufweisen. Auch OH- haltige Poly(meth)acrylate oder Polyolefine sind geeignet.

Eine weitere geeignete Gruppe von Polyolverbindungen zur Verwendung in der Komponente B sind Polyesterpolyole. Es können die für Klebstoffe bekannten Polyesterpolyole eingesetzt werden. Beispielsweise handelt es sich um die Umsetzungsprodukte von Diolen, insbesondere niedermolekularen Alkylendiolen oder Polyetherdiolen mit Dicarbonsäuren. Es kann sich dabei um aliphatische, aromatische Carbonsäuren oder Gemische davon handeln. Dem Fachmann sind solche Polyesterpolyole in vielen Ausgestaltungen bekannt und kommerziell verfügbar. Insbesondere sollen diese Polyesterpolyole ein Molekulargewicht insbesondere von 200 bis 3.000 g/mol aufweisen. Darunter sind auch polymere Lactone oder Polyacetale zu verstehen, soweit diese mindestens zwei funktionelle Gruppen aufweisen und ein entsprechendes geeignetes Molekulargewicht.

Die geeigneten Polyole, die mindestens zwei reaktive Gruppen aufweisen, können einzeln oder im Gemisch eingesetzt werden. Dabei ist darauf zu achten, dass die Verbindungen miteinander mischbar sind und bei Lagerung keine Phasentrennung auftritt. Über die Auswahl der Bestandteile der Komponente B kann die Viskosität beeinflusst werden. Werden polymere Polyole eingesetzt, zeigt Komponente B eine höhere Viskosität. Bei Verwendung von Anteilen von niedermolekularen Polyolen, beispielsweise Polyalkylenpolyolen mit bis zu 12 C- Atomen, wird die Viskosität niedriger werden. Hierbei ist es zweckmässig, wenn die Komponente B flüssig ist. Das kann durch die Auswahl der Polyole erfolgen, in einer anderen Ausführungsform ist es jedoch möglich, dass inerte organische Lösemittel zugesetzt werden.

Aus den oben beschriebenen Bindemittelkomponenten können 2K-Kaschierklebstoffe hergestellt werden. In diesen Kaschierklebstoffen kann es zweckmäßig sein, dass zusätzliche Bestandteile enthalten sind, wie beispielsweise Lösemittel, Weichmacher, Katalysatoren, Harze, Stabilisatoren, Haftvermittler, Pigmente oder Füllstoffe.

In einer Ausführungsform enthält der geeignete Klebstoff mindestens ein klebrigmachendes Harz. Es können grundsätzlich alle Harze eingesetzt werden, die verträglich sind und ein weitgehend homogenes Gemisch bilden. Als gegebenenfalls einsetzbare Stabilisatoren oder Antioxidantien sind sterisch gehinderte Phenole hohen Molekulargewichts, polyfunktionelle Phenole, schwefel- und phosphorhaltige Phenole oder Amine geeignet.

Es ist möglich, dem Klebstoff zusätzlich Silanverbindungen als Haftvermittler zuzusetzen. Als Haftvermittler können die bekannten organofunktionelle Silane, wie (meth)acryloxyfunktionelle, epoxidfunktionelle, aminfunktionelle oder nicht reaktiv substituierte Silane eingesetzt werden, insbesondere sind Methoxy oder Ethoxy - Silangruppen geeignet.

Als gegebenenfalls zusätzlich vorhandenes Additiv kann ein eingesetzter Klebstoff auch Katalysatoren enthalten. Als Katalysatoren können alle bekannten Verbindungen eingesetzt werden, die die Reaktion von OH-Gruppe und NCO-Gruppe katalysieren können. Beispiele hierfür sind Titanate, Zinncarboxylate, Zinnoxide, Organoaluminumverbindungen, tert. Aminverbindungen oder ihre Salze. Geeignete Additive sind dem Fachmann bekannt.

Andere Ausführungsformen enthalten in dem Klebstoff noch Pigmente. Es handelt sich dabei um feinteilige Pigmente, beispielsweise plättchenförmige oder Nanopartikel. Weiterhin können auch Weichmacher enthalten sein, beispielsweise Weissöle, naphtenische Mineralöle, paraffinische Kohlenwasserstofföle, Polypropylen-, Polybuten-, Polyisopren-Oligomere, hydrierte Polyisopren- und/oder Polybutadien- Oligomere, Phthalate, Adipate, Benzoatester, pflanzliche oder tierische Öle und deren Derivate. Insbesondere sind solche Weichmacher geeignet, die lebensmittelrechtlich unbedenklich sind.

Die Klebstoffe können auch Lösemittel enthalten. Es handelt sich dabei um die üblichen Lösemittel, die bei Temperaturen bis zu 120°C verdampfen können. Die Lösemittel können ausgewählt aus der Gruppe der aliphatischen Kohlenwasserstoffe, der aromatischen Kohlenwasserstoffe, Ketone oder Ester von insbesondere C2-C6-Carbonsaeuren. In einer anderen bevorzugten Ausführungsform ist der 2K-Klebstoff lösemittelfrei. Dabei kann insbesondere durch die Zusammensetzung der Komponente A und der Komponente B sichergestellt werden, dass bei Temperaturen bis zu 50°C eine niedrigviskose Mischung der Komponente A und B erhalten wird.

Ein verwendeter PU-Klebstoff besteht aus einer Komponente A, die reaktive NCO-Gruppen enthält, einer Komponente B, die reaktive NH- oder insbesondere OH-Gruppen enthält. Zusätzlich können in den Komponenten A und B, 0 bis 30 % Additive und Hilfsstoffe enthalten sein. Dabei können die Additive prinzipiell in beiden Komponenten vorliegen. Es ist jedoch darauf zu achten, dass Additive, die mit NCO reaktive Gruppen aufweisen, bevorzugt in der OH- Komponente enthalten sein sollen. Anderenfalls ist die Lagerstabilität der Produkte vermindert.

Die Komponenten A und Komponenten B sind einzeln lagerstabil. Die beiden Komponenten werden zur Anwendung so gemischt, dass ungefähr ein gleiches Äquivalentverhältnis von OH-Gruppen zu NCO-Gruppen erhalten wird. Das Mischungsverhältnis der Klebstoffe ist vorgegeben. Es kann zwischen 1:10 bis 10:1 (Volumen bezogen) betragen, insbesondere von 1:2 bis 2:1.

Die einsetzbaren 2K-PU-Klebstoffe sollen bei Auftragstemperatur von ca. 20 bis 80°C eine niedrige Viskosität aufweisen. Die Viskosität der erfindungsgemässen 2K-PU-Klebstoffe, gemessen unmittelbar nach dem Mischen der Bestandteile, soll zwischen 200 bis 10000 mPas bei Auftragstemperatur betragen, bevorzugt 500 bis 5000 mPas (bei 20 bis 60°C , Brookfield-Viskosimeter, EN ISO 2555). Eine höhere Applikationstemperatur kann möglich sein, dabei ist jedoch darauf zu achten, dass die zu verklebenden Foliensubstrate temperaturempfindlich sein können.

Nach dem Verfahren wird ein geeigneter Klebstoff als Schicht auf ein Substrat aufgetragen. Der Klebstoff soll in einer Schichtstärke von 1 g/m² bis 100 g/m² aufgetragen werden, bevorzugt von 1 bis 30 g/m² insbesondere unter 20 g/m².

Weitere in Frage kommende Klebstoffe können physikalisch abbindende oder chemisch härtende Klebstoffe sein. Bei den physikalisch abbindenden Klebstoffen handelt es sich bevorzugt um Dispersionsklebstoffe, Schmelzklebstoffe, Kontaktklebstoffe oder Plastisole. Bei den chemisch härtenden Klebstoffen handelt es sich bevorzugt um Cyanacrylat-, Methyl(meth)acrylat-, anaerob härtende-, strahlenhärtende-, Phenol-Formaldehyd-Harz-, Silikonbasierte-, Silanvernetzende-, Epoxidharzbasierte-, Polyurethan- sowie Haftklebstoffe.

### Schicht E)

Die erfindungsgemäß vorgesehene Schicht E) ist ausgewählt aus einem thermoplastischen Kunststoff.

Thermoplastische Kunststoffe für die Substratschicht sind bevorzugt Polycarbonat, Co-Polycarbonat, Polyestercarbonat, , Polystyrol, Styrol-Copolymere, aromatische Polyester wie Polyethylenterephthalat (PET), PET-Cyclohexandimethanol-Copolymer (PETG), Polyethylennaphthalat (PEN), Polybutylenterephthalat (PBT), aliphatische Polyolefine wie Polypropylen oder Polyethylen, cyclisches Polyolefin, Poly- oder Copolyacrylate und Poly- oder Copolymethacrylat wie z.B. Poly- oder Copolymethylmethacrylate (wie PMMA) sowie Copolymere mit Styrol wie z.B. transparentes Polystyrolacrylnitril (PSAN), thermoplastische Polyurethane, Polymere auf Basis von zyklischen Olefinen (z.B. TOPAS^{®}, ein Handelsprodukt der Firma Ticona), Polycarbonat Blends mit olefinischen Copolymeren oder Pfropfpolymeren, wie beispielsweise Styrol/Acrylnitril Copolymeren. Besonders bevorzugt sind Polycarbonat, Co-Polycarbonat, Polyestercarbonat, aliphatische Polyolefine wie Polypropylen oder Polyethylen, cyclisches Polyolefin PET oder PETG. Ganz besonders bevorzugt ist die Substratschicht aus Polycarbonat.

Hierbei können die vorgenannten Polymere alleine oder in Mischungen eingesetzt werden.

Polycarbonate im Sinn der vorliegenden Erfindung sind sowohl Homopolycarbonate, Copolycarbonate als auch Polyestercarbonate wie sie beispielsweise EP-A 1,657,281 sind.

Die Herstellung aromatischer Polycarbonate erfolgt z. B. durch Umsetzung von Diphenolen mit Kohlensäurehalogeniden, vorzugsweise Phosgen und/oder mit aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern, beispielsweise Monophenolen und gegebenenfalls unter Verwendung von trifunktionellen oder mehr als trifunktionellen Verzweigern, beispielsweise Triphenolen oder Tetraphenolen. Ebenso ist eine Herstellung über ein Schmelzepolymerisationsverfahren durch Umsetzung von Diphenolen mit beispielsweise Diphenylcarbonat möglich.

Diphenole zur Herstellung der aromatischen Polycarbonate und/¬oder aromatischen Polyestercarbonate sind vorzugsweise solche der Formel (I) 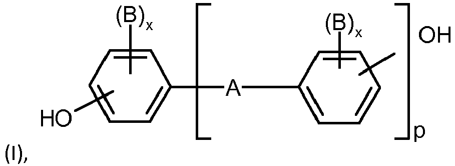 wobei
A eine Einfachbindung, C1 bis C5-Alkylen, C2 bis C5-Alkyliden, C5 bis C6-Cycloalkyli¬den, -O-, -SO-, -CO-, -S-, -SO2-, C6 bis C12-Arylen, an das weitere aromatische gegebenenfalls Heteroatome enthaltende Ringe kondensiert sein können,
   oder ein Rest der Formel (II) oder (III) 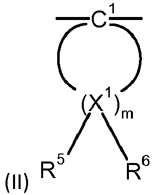 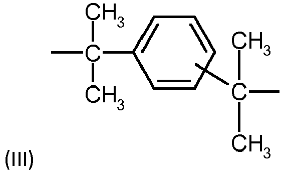
B jeweils C1 bis C12¬¬-Alkyl, vorzugsweise Methyl, Halogen, vorzugsweise Chlor und/oder Brom
x jeweils unabhängig voneinander 0, 1 oder 2,
p 1 oder 0 sind, und
R5 und R6 für jedes X1 individuell wählbar, unabhängig voneinander Wasserstoff oder C1 bis C6-Alkyl, vorzugsweise Wasserstoff, Methyl oder Ethyl,
X1 Kohlenstoff und
m eine ganze Zahl von 4 bis 7, bevorzugt 4 oder 5 bedeuten, mit der Maßgabe, dass an mindestens einem Atom X1, R5 und R6 gleichzeitig Alkyl sind.

Für die Herstellung der Polycarbonate geeignete Diphenole sind beispielsweise Hydrochinon, Resorcin, Dihydroxydiphenyle, Bis-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha-alpha'-Bis-(hydroxyphenyl)-diisopropylbenzole, Phtalimidine abgeleitet von Isatin- oder Phenolphthaleinderivaten sowie deren kernalkylierte und kernhalogenierte Verbindungen.

Bevorzugte Diphenole sind 4,4'-Dihydroxydiphenyl, 2,2-Bis-(4-hydroxyphenyl)-propan, 2,4-Bis-(4-hydroxyphenyl)-2-methylbutan, 1,1-Bis-(4-hdydroxyphenyl)-p-diisopropylbenzol, 2,2-Bis-(3-methyl-4-hydroxyphenyl)-propan, 2,2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,1-Bis-(3,5-dimethyl-4-hydroxyphenyl)-p-diisopropylbenzol, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-3,3,5-trimethylcyclohexan, und 2-Hydrocarbyl-3,3-Bis(4-Hydroxyaryl)phthalimidine sowie dem Reaktionsprodukt von N-Phenylisatin und Phenol.

Besonders bevorzugte Diphenole sind 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-cyclohexan und 1,1-Bis-(4-hydroxyphenyl)-3,3,5-trimethylcyclohexan.

Im Fall der Homopolycarbonate ist nur ein Diphenol eingesetzt, im Fall der Copolycarbonate sind mehrere Diphenole eingesetzt. Geeignete Kohlensäurederivate sind beispielsweise Phosgen oder Diphenylcarbonat.

Geeignete Kettenabbrecher, die bei der Herstellung der Polycarbonate eingesetzt werden können, sind sowohl Monophenole als auch Monocarbonsäuren. Geeignete Monophenole sind Phenol selbst, Alkylphenole wie Kresole, p-tert.-Butylphenol, Cumylphenol, p-n-Octylphenol, p-iso-Octylphenol, p-n-Nonylphenol und p-iso-Nonylphenol, Halogenphenole wie p-Chlorphenol, 2,4-Dichlorphenol, p-Bromphenol und 2,4,6-Tribromphenol, 2,4,6-Trijodphenol, p-Jodphenol, sowie deren Mischungen. Bevorzugte Kettenabbrecher sind Phenol, Cumylphenol und/oder p-tert.-Butylphenol.

Besonders bevorzugte Polycarbonate im Rahmen der vorliegenden Erfindung sind Homopolycarbonate auf Basis von Bisphenol A und Copolycarbonate auf Basis der Monomere ausgewählt aus mindestens einem der Gruppe aus Bisphenol A, 1,1-Bis-(4-hydroxyphenyl)-3,3,5-trimethylcyclohexan, 2-Hydrocarbyl-3,3-Bis(4-Hydroxyaryl)phthalimidine und den Reaktionsprodukten aus N-Phenylisatin und Phenol. Die Polycarbonate können in bekannter Weise linear oder verzweigt sein. Der Anteil der CoMonomere bezogen auf Bisphenol A beträgt im Allgemeinen bis zu 60 Gew. %, bevorzugt bis zu 50 Gew-%, besonders bevorzugt 3 bis 30 Gew-%. Mischungen von Homopolycarbonat und Copolycarbonaten können ebenfalls verwendet werden.

Polycarbonate und Co-Polycarbonate enthaltend 2-Hydrocarbyl-3,3-Bis(4-Hydroxyaryl)phthalimidine als Monomere sind unter anderem bekannt aus EP 1 582 549 A1. Polycarbonate und Co-Polycarbonate enthaltend Bisphenolmonomere basierend auf Reaktionsprodukten aus N-Phenylisatin und Phenol sind beispielsweise in WO 2008/037364 A1 beschrieben.

Die thermoplastischen, aromatischen Polycarbonate haben mittlere Molekulargewichte (Gewichtsmittel Mw, gemessen durch GPC (Gelpermeationschromatographie mit Polycarbonatstandard) von 10.000 bis 80.000 g/mol, bevorzugt 14.000 bis 32.000 g/mol, besonders bevorzugt 18.000 bis 32.000 g/mol. Im Falle spritzgegossener Polycarbonat-Formteile beträgt das bevorzugte mittlere Molekulargewicht 20.000 bis 29.000 g/mol. Im Falle von extrudierten Polycarbonat-Formteilen beträgt das bevorzugte mittlere Molekulargewicht 25.000 bis 32.000 g/mol.

Die erfindungsgemäßen thermoplastischen Kunststoffe können ferner Füllstoffe enthalten. Füllstoffe haben in der vorliegenden Erfindung die Aufgabe den thermischen Ausdehnungskoeffizienten des Polycarbonates zu verringern sowie die Permeabilität von Gasen und Wasserdampf zu regulieren bevorzugt zu verringern.

Als Füllstoffes sind Glaskugeln, Glashohlkugeln, Glasflakes, Ruße, Graphite, Kohlenstoffnanoröhrchen, Quarze, Talk, Glimmer, Silikate, Nitride, Wollastonit, sowie pyrogene oder gefällte Kieselsäuren, wobei die Kieselsäuren BET-Oberflächen von mindestens 50 m2/g (nach DIN 66131/2) aufweisen, geeignet.

Bevorzugte faserförmige Füllstoffe sind metallische Fasern, Kohlenstofffasern, Kunststofffasern, Glasfasern oder gemahlene Glasfasern, besonders bevorzugt sind Glasfasern oder gemahlene Glasfasern. Bevorzugte Glasfasern sind auch solche, die in der Ausführungsform Endlosfaser (rovings), Langglasfasern und Schnittglasfasern verwendet werden, die aus M-, E-, A-, S-, R- oder C-Glas herstellt werden, wobei E-, A-, oder C-Glas weiter bevorzugt sind.

Der Durchmesser der Fasern beträgt bevorzugt 5 bis 25 µm, weiter bevorzugt 6 bis 20 µm, besonders bevorzugt 7 bis 15 µm. Langglasfasern weisen bevorzugt eine Länge von 5 bis 50 mm, weiter bevorzugt von 5 bis 30 mm, noch weiter bevorzugt von 6 bis 15mm, und besonders bevorzugt von 7 bis 12 mm auf; sie werden beispielsweise in WO-A 2006/040087 beschrieben. Die Schnittglasfasern weisen bevorzugt zu mindestens 70 Gew.-% der Glasfasern eine Länge von mehr als 60 µm auf.

Weitere anorganische Füllstoffe sind anorganische Partikel mit Korngestalt ausgewählt aus der Gruppe, die sphärische / kubische, tabular / diskusförmige und plättchenförmiger Geometrien umfasst. Insbesondere geeignet sind anorganische Füllstoffe mit sphärischer oder plättchenförmig, bevorzugt in feinteiliger und/oder poröser Form mit großer äußerer und/oder innerer Oberfläche. Dabei handelt es sich bevorzugt um thermisch inerte anorganische Materialien insbesondere basierend auf Nitride wie Bornitrid, um Oxide oder Mischoxide wie Ceroxid, Alumimiumoxid, um Carbide wie Wolframcarbid, Siliciumcarbid oder Borcarbid gepulvertem Quarz wie Quarzmehl, amorphes SiO2, gemahlener Sand, Glaspartikel wie Glaspulver, insbesondere Glaskugeln, Silikate oder Alumosilikate, Graphit, insbesondere hochreiner synthetischer Graphit. Insbesondere bevorzugt sind dabei Quarz und Talk, am stärksten bevorzugt Quarz (sphärische Korngestalt). Diese Füllstoffe sind durch einen mittleren Durchmesser d50% von 0,1 bis 10 µm, vorzugsweise von 0.2 bis 8.0 µm, weiter bevorzugt von 0.5 bis 5 µm, gekennzeichnet.

Silikate sind durch einen mittleren Durchmesser d50 von 2 bis 10 µm, vorzugsweise von 2.5 bis 8.0 µm, weiter bevorzugt von 3 bis 5 µm, und besonders bevorzugt von 3 µm, gekennzeichnet, wobei ein oberer Durchmesser d95% von entsprechend 6 bis 34 µm, weiter bevorzugt von 6.5 bis 25.0 µm, noch weiter bevorzugt von 7 bis 15 µm, und besonders bevorzugt von 10 µm bevorzugt ist. Bevorzugt weisen die Silikate eine spezifische BET-Oberfläche, bestimmt durch Stickstoffadsorption gemäß ISO 9277, von 0.4 bis 8.0 m2/g, weiter bevorzugt von 2 bis 6 m2/g, und besonders bevorzugt von 4.4 bis 5.0 m2/g auf.

Weiter bevorzugte Silikate weisen nur maximal 3 Gew.-% Nebenbestandteile auf, wobei vorzugsweise der Gehalt an
Al2O3 < 2.0 Gew.-%,
Fe2O3 < 0.05 Gew.-%,
(CaO + MgO) <0.1 Gew.-%,
(Na2O + K2O) < 0.1 Gew.-%) ist, jeweils bezogen auf das Gesamtgewicht des Silikats.

Eine weitere vorteilhafte Ausführungsform verwendet Wollastonit oder Talk in Form von feinvermahlenen Typen mit einem mittleren Partikeldurchmesser d50 von <10 µm, bevorzugt <5 µm, besonders bevorzugt <2 µm, ganz besonders bevorzugt <1,5 µm. Die Korngrößenverteilung wird durch Windsichten bestimmt.

Die Silikate können eine Beschichtung mit silizium-organischen Verbindungen haben, wobei bevorzugt Epoxysilan-, Methylsiloxan-, und Methacrylsilan-Schlichten zum Einsatz kommen. Besonders bevorzugt ist eine Epoxysilanschlichte.

Die Füllstoffe können in einer Menge bis zu 40 Gew.-% bezogen auf die Menge an Polycarbonat zugesetzt werden. Bevorzugt sind 2,0 bis 40,0 Gew.-%, bevorzugt 3,0 bis 30,0 Gew.-%, weiter bevorzugt 5,0 bis 20,0 Gew.-%, und besonders bevorzugt 7,0 bis 14,0 Gew.-%.

Als Blendpartner für die erfindungsgemäßen thermoplastischen Kunststoffe, insbesondere für Polycarbonate, sind Pfropfpolymerisate von Vinylmonomeren auf Pfropfgrundlagen wie Dienkautuschke oder Acrylatkautschuke geeignet. Pfropfpolymerisate B sind bevorzugt solche aus
B.1 5 bis 95, vorzugsweise 30 bis 90 Gew.-%, wenigstens eines Vinylmonomeren auf
B.2 95 bis 5, vorzugsweise 70 bis 10 Gew.-% einer oder mehrerer Pfropfgrundlagen mit Glasübergangstemperaturen < 10°C, vorzugsweise < 0°C, besonders bevorzugt < -20°C.

Die Pfropfgrundlage B.2 hat im Allgemeinen eine mittlere Teilchengröße (d50-Wert) von 0,05 bis 10 µm, vorzugsweise 0,1 bis 5 µm, besonders bevorzugt 0,2 bis 1 µm.

Monomere B.1 sind vorzugsweise Gemische aus
B.1.1 50 bis 99 Gew.-Teilen Vinylaromaten und/oder kernsubstituierten Vinylaromaten (wie Styrol, *-Methylstyrol, p-Methylstyrol, p-Chlorstyrol) und/oder Methacrylsäure-(C1-C8)-Alkylester, wie Methylmethacrylat, Ethylmethacrylat), und
B.1.2 1 bis 50 Gew.-Teilen Vinylcyanide (ungesättigte Nitrile wie Acrylnitril und Methacrylnitril) und/oder (Meth)Acrylsäure-(C1-C8)-Alkylester, wie Methylmethacrylat, n-Butylacrylat, t-Butylacrylat, und/oder Derivate (wie Anhydride und Imide) ungesättigter Carbonsäuren, beispielsweise Maleinsäureanhydrid und N-Phenyl-Maleinimid.

Bevorzugte Monomere B.1.1 sind ausgewählt aus mindestens einem der Monomere Styrol, * Methylstyrol und Methylmethacrylat, bevorzugte Monomere B.1.2 sind ausgewählt aus mindestens einem der Monomere Acrylnitril, Maleinsäureanhydrid und Methylmethacrylat. Besonders bevorzugte Monomere sind B.1.1 Styrol und B.1.2 Acrylnitril.

Für die Pfropfpolymerisate B geeignete Pfropfgrundlagen B.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke.

Bevorzugte Pfropfgrundlagen B.2 sind Dienkautschuke, beispielsweise auf Basis Butadien und Isopren, oder Gemische von Dienkautschuken oder Copolymerisate von Dienkautschuken oder deren Gemischen mit weiteren copolymerisierbaren Monomeren (z.B. gemäß B.1.1 und B.1.2), mit der Maßgabe, dass die Glasübergangstemperatur der Komponente B.2 unterhalb < 10°C, vorzugsweise < 0°C, besonders bevorzugt < 10°C liegt. Besonders bevorzugt ist reiner Polybutadienkautschuk.

### Besonders bevorzugte Polymerisate B sind beispielsweise ABS-Polymerisate

(Emulsions-, Masse- und Suspensions-ABS), wie sie z.B. in der DE-OS 2 035 390 (=US PS 3 644 574) oder in der DE-OS 2 248 242 (=GB-PS 1 409 275) bzw. in Ullmanns, Enzyklopädie der Technischen Chemie, Bd. 19 (1980), S. 280 ff. beschrieben sind. Der Gelanteil der Pfropfgrundlage B.2 beträgt mindestens 30 Gew.- %, vorzugsweise mindestens 40 Gew.-% (in Toluol gemessen).

Die Pfropfcopolymerisate B werden durch radikalische Polymerisation, z.B. durch Emulsions-, Suspensions-, Lösungs- oder Massepolymerisation, vorzugsweise durch Emulsions- oder Massepolymerisation hergestellt.

Da bei der Pfropfreaktion die Pfropfmonomeren bekanntlich nicht unbedingt vollständig auf die Pfropfgrundlage aufgepfropft werden, werden erfindungsgemäß unter Pfropfpolymerisaten B auch solche Produkte verstanden, die durch (Co)Polymerisation der Pfropfmonomere in Gegenwart der Pfropfgrundlage gewonnen werden und bei der Aufarbeitung mit anfallen.

Die Polymer-Zusammensetzungen können optional noch weitere übliche Polymeradditive enthalten, wie z.B. die in EP-A 0 839 623, WO-A 96/15102, EP-A 0 500 496 oder "Plastics Additives Handbook", Hans Zweifel, 5th Edition 2000, Hanser Verlag, München) beschriebenen Antioxidantien, Thermostabilisatoren, Entformungsmittel, optischen Aufheller, UV Absorber und Lichtstreumittel in den für die jeweiligen Thermoplasten üblichen Mengen.

Die Substratschicht E) kann weiterhin eine Coextrusionschicht aus verschiedenen oder gleichen Thermoplasten sein, z.B. Polycarbonat/PMMA, Polycarbonat/PVDF oder Polycarbonat/PTFE) aber auch Polycarbonat/Polycarbonat.

Als UV-Stabilisatoren sind Benzotriazole, Triazine, Benzophenone und/oder arylierte Cyanoacrylate geeignet. Besonders geeignete UV-Absorber sind Hydroxy-Benzotriazole, wie 2-(3',5'-Bis-(1,1-dimethylbenzyl)-2'-hydroxy-phenyl)-benzotriazol (Tinuvin^{®} 234, Ciba Spezialitätenchemie, Basel), 2-(2'-Hydroxy-5'-(tert.-octyl)-phenyl)-benzotriazol (Tinuvin^{®} 329, Ciba Spezialitätenchemie, Basel), 2-(2'-Hydroxy-3'-(2-butyl)-5'-(tert.butyl)-phenyl)-benzotriazol (Tinuvin^{®} 350, Ciba Spezialitätenchemie, Basel), Bis-(3-(2H-benztriazolyl)-2-hydroxy-5-tert.-octyl)methan, (Tinuvin^{®} 360, Ciba Spezialitätenchemie, Basel), (2-(4,6-Diphenyl-1,3,5-triazin-2-yl)-5-(hexyloxy)-phenol (Tinuvin^{®} 1577, Ciba Spezialitätenchemie, Basel), sowie der Benzophenone 2,4-Dihydroxy-benzophenon (Chimasorb^{®} 22 , Ciba Spezialitätenchemie, Basel) und 2-Hydroxy-4-(octyloxy)-benzophenon (Chimassorb^{®} 81, Ciba, Basel), 2-Propenoic acid, 2-Cyano-3,3-diphenyl-, 2,2-Bis[[(2-cyano-1-oxo-3,3-diphenyl-2-propenyl)oxy]-methyl]-1,3-propanediylester (9CL) (Uvinul^{®} 3030, BASF AG Ludwigshafen), 2-[2-Hydroxy-4-(2-ethylhexyl)oxy]phenyl-4,6-di(4-phenyl)phenyl-1,3,5-triazine (CGX UVA 006, Ciba Spezialitätenchemie, Basel) oder Tetra-ethyl-2,2'-(1,4-phenylene-dimethylidene)-bismalonate (Hostavin^{®} B-Cap, Clariant AG).

Die Zusammensetzung der thermoplastischen Kunststoffe kann UV-Absorber üblicherweise in einer Menge von 0 bis 10 Gew.-%, bevorzugt 0,001 Gew.-% bis 7,000 Gew.-%, besonders bevorzugt 0,001Gew.-% bis 5,000 Gew.-% bezogen auf die Gesamtzusammensetzung enthalten.

Die Herstellung der Zusammensetzungen der thermoplastischen Kunststoffe erfolgt mit gängigen Einarbeitungsverfahren durch Zusammenführung, Vermischen und Homogenisieren der einzelnen Bestandteile, wobei insbesondere die Homogenisierung bevorzugt in der Schmelze unter Einwirkung von Scherkräften stattfindet. Gegebenenfalls erfolgt das Zusammenführen und Vermischen vor der Schmelzehomogenisierung unter Verwendung von Pulvervormischungen.

Das Substratmaterial kann als Folie oder Platte vorliegen. Die Folie kann verformt und mit einem weiteren Thermoplasten aus den oben genannten Thermoplasten hinterspritzt werden (Film Insert Molding (FIM)). Platten können thermogeformt oder mittels Drape-Forming bearbeitet bzw. kalt eingebogen werden. Auch ist eine Formgebung über Spritzguss-Prozesse möglich. Diese Prozesse sind dem Fachmann bekannt.

Die Dicke der Substratschicht muss hierbei so beschaffen sein, dass im Bauteil eine hinreichende Steifigkeit gewährleistet ist.

Im Falle einer Folie kann die Substratschicht E) durch Hinterspritzen verstärkt werden, um eine ausreichende Steifigkeit zu gewährleisten.

Die Gesamtdicke der Schicht E), d.h. einschließlich einer möglichen Hinterspritzung oder Koextrusionsschichten, beträgt im Allgemeinen 0,5mm - 10mm. Besonders bevorzugt beträgt die Dicke der Schicht E 0,8mm - 8mm, 1mm - 4mm, 2mm - 3mm. Insbesondere beziehen sich die Dickenangaben auf die Gesamtsubstratdicke bei Verwendung von Polycarbonat als Substratmaterial einschließlich einer möglichen Hinterspritzung oder Koextrusionsschichten.

In einer bevorzugten Ausführungsform wird die Schicht B) direkt auf das Substrat E) abgeschieden.

In einer weiteren bevorzugten Ausführungsform der vorliegenden Erfindung wird die Schicht B) auf eine Trägerfolie C) abgeschieden und nachfolgend die Kombination aus Schicht B) und C) über eine Klebeschicht D) auf das Substrat E gefügt.

Auf die bevorzugten Schichtfolgen BE sowie BCDE wird die Schicht A) mit der in der Schicht A) enthaltenden Klebeschicht jeweils auf die Schicht B) verklebt.

### Verwendung

Der erfindungsgemäße Mehrschichtaufbaus kann als Reflektor für Photovoltaikmodule (Concentrating Photovoltaics) und Solarmodule (Concentrating Solar Power), im Rahmen von Beleuchtungssystemen, wobei hier solche Systeme bevorzugt sind, die LEDs als Leuchtmittel verwenden, als Spiegel im Wohnbereich sowie im Fahrzeugbereich (z.B. Luft- und Schienenfahrzeuge, Busse, Nutzfahrzeuge und Kfz), Reflektoren in Lichtleitsystemen verwendet werden. Gegenstand der vorliegenden Erfindung sind daher auch Photovoltaikmodule und Solarmodule, Beleuchtungssysteme enthaltend einen erfindungsgemäßen Mehrschichtaufbau.

Die Erfindung wird durch die folgenden Beispiele näher erläutert ohne auf diese beschränkt zu sein. Die erfindunsgemäßen Beispiele geben lediglich bevorzugte Ausführungsformen der vorliegenden Erfindung wieder.

### Beispiele

Als Schicht A) wird der Solar Mirror Film 1100 von der Firma 3M verwendet.

Als Schicht E) wird eine Polycarbonat-Platte (Makrolon^{®} UV clear 2099 der Bayer MaterialScience GmbH), hergestellt über Extrusion mit einer Plattendicke von 3mm, eingesetzt.

### Beispiel 1 (erfindungsgemäß):

### Abscheidung einer SiOₓ-Schicht (Schicht B) auf Polycarbonat-Platte (Schicht E)

Die SiOx-Schicht wurde mittels reaktiven Aufdampfens abgeschieden. Dabei die Proben wurden in die Vakuumkammer eingelegt und bis auf eine Endvakuum von p< 1*10⁻⁵mbar evakuiert. Die Proben befanden sich während der ganzen Prozessphase auf einem rotierenden Probenteller. Die Proben rotierten mit ca. 20 Upm über die Beschichtungsquellen hinweg. Zuerst wurden die Proben mittels einer DC-Plamaentladung vorbehandelt. Dazu wurde für 1min bei ca. 400W bei p=0.1mbar ein Ar-Plasma gezündet. Danach folgte wieder eine Evakuierungsphase auf p< 1*10⁻⁵mbar und danach die eigentliche Beschichtung der SiOₓ-Schicht. In diesem Prozessschritt wurde mit Hilfe eines Elektronenstrahlverdampfers SiO aus einem Kohlenstoff-Tiegel verdampft. Der Prozessdruck betrug bei einem Fluss von Sauerstoff von 1.3l/h p=2*10⁻⁴ bis 5*10⁻⁴mbar. Der Quelle-Substratabstand betrug 520mm. Die Leistung wurde so eingestellt, dass sich eine Rate von 5-10 Angström/s gemessen mit einer Schwingquarzwaage ergab. Die Schicht wurde in einer Zeit von 105s abgeschieden. Als Schichtdicke ergab sich 100nm gemessen mittels Schwingquarzwaage.

### Beispiel 2 (erfindungsgemäß):

### Abscheidung einer Al2O3-Schicht (Schicht B) auf Polycarbonat-Platte (Schicht E)

Die Schicht wurde mittels gepulstem DC reaktiven Sputtern abgeschieden. Dabei die Proben wurden in die Vakuumkammer eingelegt und bis auf eine Endvakuum von p< 1*10-5mbar evakuiert. Die Proben befanden sich während der ganzen Prozessphase auf einem rotierenden Probenteller. Die Proben rotierten mit ca. 20 Upm über die Beschichtungsquellen hinweg. Zuerst wurden die Proben mittels einer Mittelfrequenz-Plasmaentladung (f=40KHz) vorbehandelt. Dazu wurde für 1min bei 500W bei p=0.1mbar ein Ar-Plasma gezündet. Danach folgte wieder eine Evakuierungsphase auf p< 1*10⁻⁵mbar und danach die eigentliche Beschichtung der AlOx-Schicht. Die Schicht wurde von einem AI-Target mittels reaktiv, gepulstem DC Sputtern mit einer Pulsfrequenz von 150 kHz abgeschieden. Als Beschichtungsquelle wurde ein rundes Planarmagnetron ION'X-8"HV von Thin Film Consulting mit einem Durchmesser von 200mm verwendet, die mit einem Generator Advanced Energy "Pinnacle™ Plus+ 5kW" betrieben wurde. Zuerst wurde das Target bei geschlossener Blende für 1min freigesputtert und dann bei offener Blende innerhalb von 8min 20sek. bei 340V im spannungsgeregeltem Mode und einem Gesamtdruck von p= 5·10⁻³ mbar die AlOx-Schicht auf der Silberschicht abgeschieden. Das O2/Ar-Verhältnis wurde auf 8% eingestellt. Als Schichtdicke ergab sich 170nm mittels Stufenabtaster wie unten beschrieben. Die Abstand Substrat - Beschichtungsquelle betrug immer 80mm.

### Einstellung der Schichtdicken:

Zur Einstellung der Schichtdicken erfolgte zunächst eine Kalibrierung der Prozessparameter. Hierzu wurden unterschiedliche Schichtdicken bei definierten Prozessparametern auf einen Objektträger abgeschieden, der zur Erzeugung einer Stufe in der Mitte mit einem Klebestreifen versehen wurde. Nach Abscheidung der jeweiligen Schicht wurde der Klebestreifen entfernt und die Höhe der entstandenen Stufe mit einem Stufenabtaster KLA Tencor Alpha-Step 500 Surface Profiler von Tencor Instruments bestimmt.

Hierdurch werden Prozessparameter ermittelt, die für die Herstellung der gewünschten Zielschichtdicken eingestellt werden müssen.

### Beispiel 3 (erfindungsgemäß):

### Abscheidung einer Aluminium-Schicht (Schicht B) auf Polycarbonat-Platte (Schicht E)

Herstellungsverfahren: Die Schicht wurde mittels DC Sputtern abgeschieden. Zuerst wurde die PC Platte in die Vakuumkammer eingeschleust und bis auf p< 2·10⁻⁵ mbar evakuiert. Dann folgte die Plasmavorbehandlung: Die PC Platte wurde 1min bei 500W und 0,1 mbar Ar im Mittelfrequenz-Plasma (40kHz) vorbehandelt. Die Aluminium-Schicht wurde mittels DC Sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Aluminium) bei geschlossener Blende für 2min freigesputtert und dann bei offener Blende innerhalb von 130s mit 2000W und einem Druck von p= 5·10⁻³ mbar die Al-Schicht abgeschieden. Die Proben wurden während allen Beschichtungsschritten über die Beschichtungsquellen mit ca. 20rpm rotiert, um die Homogenität der Beschichtung zu erhöhen. Die Abstand Substrat - Beschichtungsquelle betrug immer 80mm. Die resultierende Schichtdicke der Aluminiumschicht auf dem Substrat resultierte zu 145nm.

### Beispiel 4 (Vergleichsbeispiel)

Abscheidung einer SiO₂-Schicht (Schicht B), die nach einem Sol-Gel-Verfahren, das z.B. in der US-Pat. Nr. 4,410,594, sowie der US-Pat. Nr. 5,041,313 näher beschrieben ist, produziert wurde, auf Polycarbonat-Platte (Schicht E). Derartige Beschichtungsmittel sind kommerziell von der Fa. Momentive Performance Materials als Kombinationen aus Primer SHP401 sowie Decklack AS4000 erhältlich.

Die Applikation des Beschichtungsmittels SHP401 durch Fluten erfolgte bei einer Temperatur von 23°C und 37% relativer Luftfeuchte durch Fluten auf eine Polycarbonat-Platte. Die derart beschichtete Platte wurde für 30 Minuten bei einer Temperatur von 23°C und 37% relativer Luftfeuchte hängend gelagert. Anschließend erfolgte die Applikation des Beschichtungsmittels AS4000 durch Fluten bei einer Temperatur von 23°C und 37% relativer Luftfeuchte durch Fluten. Die derart beschichtete Platte wurde für 30 Minuten bei einer Temperatur von 23°C und 37% relativer Luftfeuchte hängend gelagert. Abschließend wurden die Beschichtungen auf der Platte im Umluft-Trockenschrank für 60 Minuten bei einer Temperatur von 130°C gehärtet.

### Beispiel 5 (Vergleichsbeispiel)

### Polycarbonat-Platte (Schicht E) ohne Oberflächenmodifikation (Schicht B)

Hierbei handelt es sich um eine Polycarbonat-Massivplatte (Makrolon^{®} UV clear 2099 der Bayer MaterialScience GmbH), hergestellt über Extrusion mit einer Plattendicke von 3mm.

### Beispiel 6 (erfindungsgemäß)

### Einbringung einer SiOₓ-Barriereschicht (Schicht B) durch Lamination auf Polycarbonat-Platte (Schicht E)

Eine SiOₓ-Schicht (Schicht B) auf einer 50µm dicken PET-Folie (Schicht C), eingesetzt in Form des Produktes CERAMIS CTXA50 der Fa. Amcor, wurde mit Hilfe eines 2-Komponenten Klebemittels Liofol LA 8192-22 / LA 7394 (Mischungsverhältnis von Polyol zu isocyanatbasiertem Härter 1:1, Schicht D) der Fa. Henkel auf eine Polycarbonat Platte (Schicht E) gefügt.

Auf die derart präparierten Beispiele 1 bis 6 wurde die Schicht A) unter Nutzung der in Schicht A) enthaltenen Klebeschicht in der Art gefügt, dass keine Lufteinschlüsse zwischen Schicht A) und dem darunterliegenden Aufbau gemäß der Beispiele 1 bis 6, zu erkennen waren. Hierbei wurden die Aufbauten gemäß Beispiel 1 bis 6 so platziert, dass die Schicht E), außer im Fall von Beispiel 5, nicht in Kontakt mit Schicht A) kommt. Hierzu wurde die Schicht A) in schräger Position mit einer Kante auf die Aufbauten gemäß der Beispiele 1 bis 6 gehalten. Mit einer handelsüblichen Gummirolle wurde dann die Schicht A langsam auf die Aufbauten gemäß der Beispiele 1 bis 6 unter Druck aufgerollt. Eingeschlossene Luftblasen wurden mit der handelsüblichen Gummirolle zum Rand des Verbundes herausgedrückt, wo die eingeschlossenen Luftblasen entweichen konnten.

Die Laminate wurden am Rand umlaufend mit dem Klebeband S53L10M der Fa. Stokvis Deutschland GmbH versiegelt.

Zur Simulation äußerer Einflüsse wurden die am Rand versiegelten Laminate unterschiedlichen Klimalagerungen in einem Vötsch Klimaprüfschrank VC³ 7018 ausgesetzt, die nachfolgend beschrieben sind.

**Tabelle 1:**

| Prüfung | Bedingungen |
|---|---|
| Klimawechsel-Test (DIN EN 62108 10.6 & 10.8) | 400 Zyklen Temperaturwechsel von -40°C bis 65°C ohne Feuchte (14 Zyklen pro Tag) gefolgt von |
| | 40 Zyklen Feuchte-Frost-Test (20h bei 85°C / 85% relativer Feuchte gefolgt von 4h Abkühlung auf -40°C und danach wieder aufheizen auf 85°C / 85% relativer Feuchte) |
| Damp-Heat-Test (DIN EN 62108 10.7) | 2000 Stunden 65°C bei 85% relativer Feuchte |

Nach diesen Belastungen wurden die Laminate auf Blasenbildung hin visuell beurteilt. Die Beurteilung ist in nachfolgender Tabelle zusammengefasst. Laminate bei denen eine Blasenbildung auftrat, zeigten folglich auch eine geringere Haftung der Schicht A auf dem oberflächenmodifizierten Substrat.

**Tabelle 2:**

| Beispiel | Klimawechsel-Test | Damp-Heat-Test |
|---|---|---|
| 1 | keine Blasenbildung | keine Blasenbildung |
| 2 | keine Blasenbildung | keine Blasenbildung |
| 3 | keine Blasenbildung | keine Blasenbildung |
| 4 | starke Blasenbildung nach 200 Zyklen | starke Blasenbildung nach 1000 Std. |
| 5 | starke Blasenbildung | nicht geprüft |
| 6 | keine Blasenbildung | keine Blasenbildung |

### Ergebnis

Die Beispiele 1 bis 3 zeigen deutlich, dass zur Verklebung von Folien (Schicht A) mit einer Klebeschicht (enthalten in Schicht A) eine gezielte Oberflächenmodifikation der Polycarbonat-Platten (Schicht E) notwendig ist. Das Fehlen (Beispiel 5) oder gar eine falsche Oberflächenmodifikation (Beispiel 4) resultiert in dem verstärkten Auftreten von Blasen nach den beschriebenen Belastungen und somit zu einer eingeschränkten Verwendung dieser Laminate. Das Einbringen der Oberflächenmodifikation kann auch durch Lamination einer entsprechenden Kombination aus Schichten B, C und D erfolgen (Beispiel 6).

## Patentansprüche

1. Mehrschichtaufbau enthaltend
A) eine Funktionsfolie enthaltend eine VIS/IR-reflektierende Metallschicht auf einer Trägerfolie, wobei die Trägerfolie einschichtig oder in Form einer UV- und/oder UV/VIS-reflektierenden Multilagenschicht ausgeführt sein kann, sowie mindestens eine Klebeschicht, wobei die Klebeschicht ein Pressure Sensitive Adhesive ist, sowie optional mindestens eine Kratzfestschicht,
B) eine Funktionsschicht enthaltend eine Schicht ausgewählt aus mindestens einem aus der Gruppe der Metallnitride, Metall- oder Halbmetalloxide, Mischoxide oder Metalle, wobei die Schicht zusätzlich eine Lackierung aufweisen kann,
C) optional eine Trägerfolie,
D) optional eine Klebeschicht, und
E) eine thermoplastische Substratschicht.

2. Mehrschichtaufbau nach Anspruch 1, **dadurch gekennzeichnet, dass** die VIS/IR reflektierende Metallschicht der Funktionsfolie A) Aluminium, Silber und/oder Kupfer, bevorzugt Silber und/oder Kupfer, besonders bevorzugt Silber enthält.

3. Mehrschichtaufbau nach Anspruch 2, **dadurch gekennzeichnet, dass** die Klebeschicht in A) ein Pressure Sensitive Adhesive ist, ausgewählt aus der Gruppe bestehend aus Acrylaten, Polyurethanen, Polyharnstoffen, Polyalphaolefinen, Siliconen, oder natürlichem oder synthetischem Kautschuk, bevorzugt Acrylate, Polyurethane und Polyharnstoffe, besonders bevorzugt Acrylate.

4. Mehrschichtaufbau nach Anspruch 3, **dadurch gekennzeichnet, dass** die Funktionsschicht B Aluminium, Kupfer, Silber, Titan, Chrom, Chromlegierungen, VA-Stahl, Gold, Platin, Aluminiumoxid, Titandioxid, Siliziumoxid SiOₓ, Tantalpentoxid Ta₂O₅, Zirkonoxid, Zirkondioxid, Nb₂O₅, HfO, Zink-Zinnoxid, Indium-Zinnoxid, Aluminium-Zinkoxid, Siliziumnitrid, Bornitrid oder Titannitrid, bevorzugt Aluminium, VA-Stahl, Kupfer, Titan, Aluminiumoxid, Siliziumoxid SiOₓ, Siliziumnitrid oder Zink-Zinnoxid enthält.

5. Mehrschichtaufbau nach Anspruch 4, **dadurch gekennzeichnet, dass** die Dicke der Schicht aus Metallnitriden, Metall- oder Halbmetalloxiden, Mischoxiden oder Metallen innerhalb der Funktionsschicht B) 5 nm bis 300 nm, bevorzugt 10 nm bis 200 nm, besonders bevorzugt 20 nm bis 180 nm beträgt.

6. Mehrschichtaufbau nach Anspruch 1, **dadurch gekennzeichnet, dass** der Mehrschichtaufbau eine Trägerfolie C) enthält, **dadurch gekennzeichnet, dass** die Trägerfolie einen thermoplastischen Kunststoff, ausgewählt aus der Gruppe bestehend aus Polylmethacrylaten, Polyethylenterephthalat, Polyethylenterephthalat- Cyclohexandimethanol-Copolymer, Polyethylennaphthalat, Polycarbonat, Co-Polycarbonat oder Polyestercarbonat, enthält.

7. Mehrschichtaufbau nach Anspruch 6, **dadurch gekennzeichnet, dass** der Mehrschichtaufbau eine Klebeschicht D) enthält, **dadurch gekennzeichnet, dass** die Klebeschicht D) Dispersionsklebstoffe, Schmelzklebstoffe, Kontaktklebstoffe, Plastisole, Cyanacrylate, Methyl(meth)acrylate, anaerob härtende-, strahlenhärtende-, Phenol-Formaldehyd-Harze, Silikone, Silanvernetzende Polymerklebstoffe, Epoxidharze, Polyurethane sowie Haftklebstoffe, bevorzugt Schmelzklebstoffe oder Polyurethane enthält.

8. Mehrschichtaufbaunach Anspruch 1, **dadurch gekennzeichnet, dass** die Substratschicht E) einen thermoplastischen Kunststoff, bevorzugt Polycarbonat, Co-Polycarbonat, Polyestercarbonat, aliphatische Polyolefine, cyclisches Polyolefin, Polyethylenterephthalat oder Cyclohexandimethanol-Copolymer, besonders bevorzugt Polycarbonat, enthält.

9. Mehrschichtaufbau nach einem der vorigen Ansprüche, **dadurch gekennzeichnet, dass** die Schicht B) in einem Vakuum-Abscheideverfahren auf Schicht C) oder Schicht E) aufgebracht ist.

10. Verfahren zur Herstellung eines Mehrschichtaufbaus gemäß einem oder mehreren der voranstehenden Ansprüche, **dadurch gekennzeichnet, dass**
I. die Schicht B) in einem Vakuum-Abscheideverfahren auf Schicht C) oder Schicht E) aufgebracht wird oder
II. bei einem Mehrschichtaufbau enthaltend die Schichten A) bis E),
a) die Schichten A) und B) und C) mittels einer Klebeschicht D) auf die Substratschicht E) aufgebracht wird oder
b) die Schicht B) auf eine Trägerfolie C) aufgebracht wird, die so erhaltene Folie mittels einer Klebeschicht D) auf eine Substratschicht E) aufgebracht wird und anschließend die Schicht A) aufgebracht wird.

11. Verwendung eines Mehrschichtaufbaus gemäß Anspruch 1 als Reflektor für Photovoltaikmodule, Solarmodule, Beleuchtungssysteme, als Spiegel im Wohnbereich sowie im Fahrzeugbereich umfassend Luft- und Schienenfahrzeuge, Busse, Nutzfahrzeuge und Kraftfahrzeuge sowie in Lichtleitsystemen.

12. Reflektor für Photovoltaikmodule, Solarmodule, Beleuchtungssysteme, Spiegel im Wohnbereich sowie im Fahrzeugbereich enthaltend einen Mehrschichtaufbau gemäß Anspruch 1.

## Claims

1. Multilayer structure comprising
A) a functional film comprising a VIS/IR-reflecting metal layer on a carrier film, wherein the carrier film can be in single-layer form or in the form of a UV- and/or UV/VIS-reflecting multi-ply layer, and at least one adhesive layer, wherein the adhesive layer is a pressure sensitive adhesive, and optionally at least one scratch-resistant layer,
B) a functional layer comprising a layer selected from at least one from the group of the metal nitrides, metal oxides or semimetal oxides, mixed oxides or metals, wherein the layer can additionally have a coating,
C) optionally a carrier film,
D) optionally an adhesive layer, and
E) a thermoplastic substrate layer.

2. Multilayer structure according to claim 1, **characterised in that** the VIS/IR-reflecting metal layer of the functional film A) comprises aluminium, silver and/or copper, preferably silver and/or copper, particularly preferably silver.

3. Multilayer structure according to claim 2, **characterised in that** the adhesive layer in A) is a pressure sensitive adhesive selected from the group consisting of acrylates, polyurethanes, polyureas, polyalphaolefins, silicones, or natural or synthetic rubber, preferably acrylates, polyurethanes and polyureas, particularly preferably acrylates.

4. Multilayer structure according to claim 3, **characterised in that** the functional layer B comprises aluminium, copper, silver, titanium, chromium, chromium alloys, stainless steel, gold, platinum, aluminium oxide, titanium dioxide, silicon oxide SiOₓ, tantalum pentoxide Ta₂O₅, zirconium oxide, zirconium dioxide, Nb₂O₅, HfO, zinc-tin oxide, indium-tin oxide, aluminium-zinc oxide, silicon nitride, boron nitride or titanium nitride, preferably aluminium, stainless steel, copper, titanium, aluminium oxide, silicon oxide SiOₓ, silicon nitride or zinc-tin oxide.

5. Multilayer structure according to claim 4, **characterised in that** the thickness of the layer of metal nitrides, metal oxides or semimetal oxides, mixed oxides or metals within the functional layer B) is from 5 nm to 300 nm, preferably from 10 nm to 200 nm, particularly preferably from 20 nm to 180 nm.

6. Multilayer structure according to claim 1, **characterised in that** the multilayer structure comprises a carrier film C), **characterised in that** the carrier film comprises a thermoplastic plastic selected from the group consisting of polymethacrylates, polyethylene terephthalate, polyethylene terephthalate-cyclohexanedimethanol copolymer, polyethylene naphthalate, polycarbonate, copolycarbonate or polyester carbonate.

7. Multilayer structure according to claim 6, **characterised in that** the multilayer structure comprises an adhesive layer D), **characterised in that** the adhesive layer D) comprises dispersion adhesives, hot melt adhesives, contact adhesives, plastisols, cyanoacrylates, methyl (meth)acrylates, anerobically curing, radiation-curing, phenol-formaldehyde resins, silicones, silane-crosslinking polymer adhesives, epoxy resins, polyurethanes and pressure sensitive adhesives, preferably hot melt adhesives or polyurethanes.

8. Multilayer structure according to claim 1, **characterised in that** the substrate layer E) comprises a thermoplastic plastic, preferably polycarbonate, copolycarbonate, polyester carbonate, aliphatic polyolefins, cyclic polyolefin, polyethylene terephthalate or cyclohexanedimethanol copolymer, particularly preferably polycarbonate.

9. Multilayer structure according to any one of the preceding claims, **characterised in that** layer B) is applied by a vacuum deposition process to layer C) or layer E).

10. Process for the production of a multilayer structure according to one or more of the preceding claims, **characterised in that**
I. layer B) is applied by a vacuum deposition process to layer C) or layer E), or
II. in the case of a multilayer structure comprising layers A) to E)
a) layers A) and B) and C) are applied by means of an adhesive layer D) to the substrate layer E), or
b) layer B) is applied to a carrier film C), the film so obtained is applied by means of an adhesive layer D) to a substrate layer E), and layer A) is then applied.

11. Use of a multilayer structure according to claim 1 as a reflector for photovoltaic modules, solar modules, lighting systems, as a mirror in the residential sector and in the automotive sector including aircraft and railway vehicles, buses, commercial vehicles and cars, and in fibre-optic systems.

12. Reflector for photovoltaic modules, solar modules, lighting systems, mirrors in the residential sector and in the automotive sector, comprising a multilayer structure according to claim 1.

## Revendications

1. Structure multicouche, contenant :
A) une feuille fonctionnelle contenant une couche métallique réfléchissant la lumière VIS/IR sur une feuille support, la feuille support pouvant être configurée à une couche ou sous la forme d'une couche multicouche réfléchissant la lumière UV et/ou UV/VIS, ainsi qu'au moins une couche adhésive, la couche adhésive étant un adhésif sensible à la pression, ainsi qu'éventuellement au moins une couche résistante aux éraflures,
B) une couche fonctionnelle contenant une couche choisie parmi au moins un élément du groupe constitué par les nitrures métalliques, les oxydes de métaux ou de semi-métaux, les oxydes mixtes ou les métaux, la couche pouvant en outre comprendre un vernissage,
C) éventuellement une feuille support,
D) éventuellement une couche adhésive et
E) une couche de substrat thermoplastique.

2. Structure multicouche selon la revendication 1, **caractérisée en ce que** la couche métallique réfléchissant la lumière VIS/IR de la feuille fonctionnelle A) contient de l'aluminium, de l'argent et/ou du cuivre, de préférence de l'argent et/ou du cuivre, de manière particulièrement préférée de l'argent.

3. Structure multicouche selon la revendication 2, **caractérisée en ce que** la couche adhésive A) est un adhésif sensible à la pression choisi dans le groupe constitué par les acrylates, les polyuréthanes, les polyurées, les poly-alpha-oléfines, les silicones ou le caoutchouc naturel ou synthétique, de préférence les acrylates, les polyuréthanes et les polyurées, de manière particulièrement préférée les acrylates.

4. Structure multicouche selon la revendication 3, **caractérisée en ce que** la couche fonctionnelle B) contient de l'aluminium, du cuivre, de l'argent, du titane, du chrome, des alliages de chrome, de l'acier VA, de l'or, du platine, de l'oxyde d'aluminium, du dioxyde de titane, de l'oxyde de silicium SiOₓ, du pentoxyde de tantale Ta₂O₅, de l'oxyde de zirconium, du dioxyde de zirconium, Nb₂O₅, HfO, de l'oxyde de zinc et d'étain, de l'oxyde d'indium et d'étain, de l'oxyde d'aluminium et d'étain, du nitrure de silicium, du nitrure de bore ou du nitrure de titane, de préférence de l'aluminium, de l'acier VA, du cuivre, du titane, de l'oxyde d'aluminium, de l'oxyde de silicium SiOₓ, du nitrure de silicium ou de l'oxyde de zinc et d'étain.

5. Structure multicouche selon la revendication 4, **caractérisée en ce que** l'épaisseur de la couche de nitrures métalliques, d'oxydes de métaux ou de semi-métaux, d'oxydes mixtes ou de métaux dans la couche fonctionnelle B) est de 5 nm à 300 nm, de préférence de 10 nm à 200 nm, de manière particulièrement préférée de 20 nm à 180 nm.

6. Structure multicouche selon la revendication 1, **caractérisée en ce que** la structure multicouche contient une feuille support C), **caractérisée en ce que** la feuille support contient un plastique thermoplastique, choisi dans le groupe constitué par les polyméthacrylates, un polyéthylène téréphtalate, un copolymère de polyéthylène téréphtalate, de cyclohexanediméthanol, un polyéthylène naphtalate, un polycarbonate, un co-polycarbonate ou un polyester-carbonate.

7. Structure multicouche selon la revendication 6, **caractérisée en ce que** la structure multicouche contient une couche adhésive D), **caractérisée en ce que** la couche adhésive D) contient des adhésifs en dispersion, des adhésifs fusibles, des adhésifs de contact, des plastisols, des cyanoacrylates, des (méth)acrylates de méthyle, des résines à durcissement anaérobie, à durcissement par rayonnement, de phénol-formaldéhyde, des silicones, des adhésifs polymères à réticulation silane, des résines époxydes, des polyuréthanes, ainsi que des adhésifs sensibles à la pression, de préférence des adhésifs fusibles ou des polyuréthanes.

8. Structure multicouche selon la revendication 1, **caractérisée en ce que** la couche de substrat E) contient un plastique thermoplastique, de préférence un polycarbonate, un co-polycarbonate, un polyester-carbonate, des polyoléfines aliphatiques, une polyoléfine cyclique, un polyéthylène téréphtalate ou un copolymère de cyclohexanediméthanol, de manière particulièrement préférée un polycarbonate.

9. Structure multicouche selon l'une quelconque des revendications précédentes, **caractérisée en ce que** la couche B) est appliquée sur la couche C) ou la couche E) par un procédé de dépôt sous vide.

10. Procédé de fabrication d'une structure multicouche selon une ou plusieurs des revendications précédentes, **caractérisé en ce que**
I. la couche B) est appliquée sur la couche C) ou la couche E) par un procédé de dépôt sous vide, ou
II. pour une structure multicouche contenant les couches A) à E),
a) les couches A) et B) et C) sont appliquées sur la couche de substrat E) au moyen d'une couche adhésive D), ou
b) la couche B) est appliquée sur une feuille support C), la feuille ainsi obtenue est appliquée sur une couche de substrat E) au moyen d'une couche adhésive D), puis la couche A) est appliquée.

11. Utilisation d'une structure multicouche selon la revendication 1 en tant que réflecteur pour des modules photovoltaïques, des modules solaires, des systèmes d'éclairage, en tant que miroir dans le secteur résidentiel, ainsi que dans le domaine des véhicules y compris les avions et les véhicules ferroviaires, les bus, les véhicules utilitaires et les véhicules automobiles, ainsi que dans les systèmes de conducteurs optiques.

12. Réflecteur pour modules photovoltaïques, modules solaires, systèmes d'éclairage, miroirs dans le secteur résidentiel et dans le domaine des véhicules, contenant une structure multicouche selon la revendication 1.
